Europäisches Patentamt

European Patent Office

Office européen des brevets

(19)

(11) Veröffentlichungsnummer : **0 133 883**
**B1**

(12) **EUROPÄISCHE PATENTSCHRIFT**

(45) Veröffentlichungstag der Patentschrift :
30.09.87

(21) Anmeldenummer : 84106813.3

(22) Anmeldetag : 14.06.84

(51) Int. Cl.⁴ : **H 01 R 43/02, B 23 K 20/10**

(54) Ultraschallverbinder.

(30) Priorität : 30.06.83 DE 3323576
25.10.83 DE 3338757

(43) Veröffentlichungstag der Anmeldung :
13.03.85 Patentblatt 85/11

(45) Bekanntmachung des Hinweises auf die Patenterteilung : 30.09.87 Patentblatt 87/40

(84) Benannte Vertragsstaaten :
AT BE DE FR GB IT NL

(56) Entgegenhaltungen :
DE-A- 2 723 029
DE-B- 2 641 508
FR-A- 1 337 545
FR-A- 2 501 923
US-A- 3 708 878
US-A- 4 155 499

(73) Patentinhaber : Siemens Aktiengesellschaft Berlin
und München
Wittelsbacherplatz 2
D-8000 München 2 (DE)

(72) Erfinder : Moll, Helmut
Haselhofstrasse 32
D-8520 Erlangen (DE)

## Beschreibung

Die Erfindung bezieht sich auf Ultraschallverbinder zum Herstellen nicht lösbarer elektrischer Verbindungen von Drähten und/oder Litzen untereinander sowie Drähten und/oder Litzen mit separaten Anschlußelementen gemäß dem Oberbegriff des Patentanspruches 1.

Auf vielen Gebieten der Technik besteht die Forderung, nicht lösbare elektrische Verbindungen herzustellen, beispielsweise zwischen lackierten Drähten und blanken, verzinnten oder isolierten Litzen, ohne vorher die isolierende Lackschicht von den Drähten entfernen zu müssen. Nach derzeitigem Stand der Technik sind dazu verschiedene Verfahren bekannt.

Sehr verbreitet ist die sogenannte Crimp-Technik : Damit können kombiniert Lackdrähte und/oder Litzen als End- und Durchgangsverbinder mechanisch mittels eines speziellen Verbindungselementes verbunden werden. Es werden aber dazu jeweils ganz spezifische, auf die Leiterabmessungen abgestellte Verbindungselemente benötigt, um durch Klemmwirkung gleichzeitig den elektrischen Kontakt herzustellen. Solche Verbindungselemente sind begrenzt im Aufnahmequerschnitt und jeweils auf eine bestimmte Anzahl von Draht- oder Litzenleitern abgestellt, wobei die zulässigen Schwankungen in den Leiterabmessungen für das jeweilige Verbindungselement gering sind. Durch die Vielzahl der im einzelnen notwendigen Verbindungselemente wird das Crimp-Verfahren vergleichsweise aufwendig ; außerdem ist die damit hergestellte Verbindung nicht immer dauerfest.

Drähte mit lotfähigen Lackisolierungen können daneben auch in konventionellen Lötbädern gelötet werden. Allerdings sind bei den hauptsächlich eingesetzten schwer lotfähigen Lackisolierungen Lötbadtemperaturen mit ca. 500 °C erforderlich, wodurch wegen der starken Krätzebildung ein erhöhter Lotverbrauch nicht zu vermeiden ist. Weiterhin ist bei dieser Verbindungstechnik für speziell nicht abisolierte, lackbeschichtete Drähte, beispielsweise von Spulen, nachteilig, daß aufgrund der vergleichsweise hohen Temperaturen zusätzliche Absaugeinrichtungen erforderlich sind und daß der Spulenkörper selbst durch hohe Temperaturbelastungen beeinträchtigt werden könnte. Außerdem müssen kunststoffisolierte Litzen vorher abisoliert werden.

Weiterhin wurde auch bereits vorgeschlagen, nicht lösbare Verbindungen von Kabelanschlüssen durch Ultraschallverschweißung herzustellen (PRAKTIKER 8/83, S. 361 bis 363). Diese Schweißtechnik wird im zunehmendem Maße zum Verbinden von metallischen Werkstücken verwendet, wobei von der schwingenden Sonotrode der Ultraschall direkt auf das eine, als aktives Teil bezeichnete Werkstück übertragen wird, während das das andere, als passives Teil bezeichnete Werkstück ortsfest im Amboß angeordnet ist. Die Verschweißung erfolgt entlang der gemeinsamen Fügefläche. Dabei ist vorteilhaft, daß die Werkstücke an den Fügeflächen nicht oberflächenbehandelt werden müssen, weil Schmutz und Oxidschichten und in Sonderfällen auch Fettschichten nicht hinderlich sind. Insbesondere Isolationsschichten brauchen vor der Verschweißung nicht zwingend entfernt zu werden.

Das Ultraschallverschweißen von Drähten und/oder Litzen untereinander sowie Drähten und/oder Litzen mit Anschlußteilen ist jedoch dann nicht beherrschbar, wenn mehrere isolierte Einzeldrähte und/oder isolierte Litzen vorliegen. Eine sukzessive Einzelverschweißung wäre zu langwierig und aufwendig, wobei sich durch die Ultraschalleinwirkung bereits geschweißte Verbindungen wieder lösen könnten. Zwar sind bereits in der FR-A-2 501 923 ein Verfahren und ein zugehöriger mechanischer Verbinder beschrieben, mit denen eine dauerhafte Verbindung von Kabellitzen erreicht werden soll ; jedoch ist dort die eigentliche mechanische Verbindung nach Art des Crimpen entscheidend, während das Ultraschallschweißen nur unterstützend erfolgt. Demzufolge sind die dort verwendeten Verbindungselemente als Formteile mit Biegelaschen ausgebildet.

Aufgabe der Erfindung ist es daher, einen Ultraschallverbinder anzugeben, mit dem Drähte und/oder Litzen in einfacher Weise durch Ultraschallverschweißung verbunden werden können.

Die Aufgabe ist erfindungsgemäß durch die Gesamtheit der Merkmale des Patentanspruches 1 gelöst. Vorteilhafte Weiterbildungen des Ultraschallverbinders sind in den abhängigen Ansprüchen, insbesondere im Anspruch 5, angegeben.

Für die erfindungsgemäßen Ultraschallverbinder kann die Ultraschallschweißeinrichtung mit Sonotrode und Amboß als zugehörigem Werkzeug speziell auf die verwendeten Ultraschallverbinder abgestellt sein. Die Schwingungsrichtung der Sonotrode verläuft in Längsrichtung des Ultraschallverbinders, wobei die Wirkungsfläche der Sonotrode vorzugsweise in dieser Richtung abgerundet ist. Damit wird gewährleistet, daß bei der Verschweißung eine unterschiedliche Verformung des Ultraschallverbinders mit einem gleichmäßigen Übergang der verformten Drähte zum Ausgangsquerschnitt der Gesamtheit der Drähte und/oder Litzen vorliegt. Der Amboß der Schweißeinrichtung ist dagegen vorteilhafterweise derart ausgebildet, daß er den passiven Teil des Ultraschallverbinders aufnehmen kann.

Im Rahmen der Erfindung kann der Deckel mit seiner Breite der Außenbreite des Profilteiles entsprechen. Die Breite des Deckels kann aber auch der Innenbreite des Profilteiles entsprechen, so daß er vor der Verschweißung in das Profilteil einlegbar ist. Darüber hinaus kann der Deckel in Längsrichtung des Ultraschallverbinders v-förmig gebogensein, so daß bei der Ultraschallverschweißung eine optimale Verschweißung des Randbereiches des Deckels mit den Schenkeln des Aufnahmeteiles und den darin eingelegten Drähten und/oder Litzen möglich ist. Dadurch wird bereits ein Verschweißen der Drähte und/oder Litzen an ihren Berührungstellen bei geringer Verformung erreicht.

Es ist auch möglich, den Ultraschallverbinder derart auszubilden, daß das Profilteil an seiner Rückseite selbst als elektrisches Anschlußelement, beispielsweise als Ring oder Lasche, ausgebildet ist. Dies ist dann sinnvoll, wenn Drähte und/oder Litzen zusammen einen elektrischen Anschluß bilden sollen.

In einer bevorzugten Ausführungsform des Ultraschallverbinders bilden das Profilteil und die Deckelplatte ein gemeinsames Formteil, bei dem die Deckelplatte über eine oder mehrere kleine Anbindungen, beispielsweise einen Steg, mit dem u-förmigen Profilteil verbunden ist. Bei einer solchen Ausbildung des Ultraschallverbinders braucht im Fertigungsbetrieb mit dem erfindungsgemäßen Verfahren nur ein einziges Teil zugeführt werden, wobei zum Schweißen die Deckplatte über den eingelegten Leiter geklappt wird. Da die Anbindung des Deckels am Unterteil schmal ausgebildet sein kann, schwingt die Deckplatte beim Schweißen ungehindert mit und kann auch abreißen, so daß sich eine gute Schweißverbindung ergibt.

Die mit der Erfindung geschaffenen Ultraschallverbinder aus aktivem und passivem Teil können aus den üblichen, für die Ultraschallverschweißung geeigneten Materialien bestehen. Dabei kann es zweckmäßig sein, für das aktive und passive Teil unterschiedliche Materialien zu wählen.

Weitere Einzelheiten und Vorteile der Erfindung ergeben sich aus der nachfolgenden Figurenbeschreibung von Ausführungsbeispielen anhand der Zeichnung. Es zeigen jeweils in schematischer Darstellung.

Figur 1 eine Ultraschallschweißeinrichtung mit einem eingelegten Ultraschallverbinder,

Figuren 2 und 3 zwei alternativ zu verwendende Ultraschallverbinder im Querschnitt,

Figur 4 einen Ultraschallverbinder mit integriertem Anschlußelement in der Draufsicht und

Figur 5 einen einteiligen Ultraschallverbinder in perspektivischer Darstellung.

In den Figuren sind identische Teile mit den gleichen Bezugszeichen versehen.

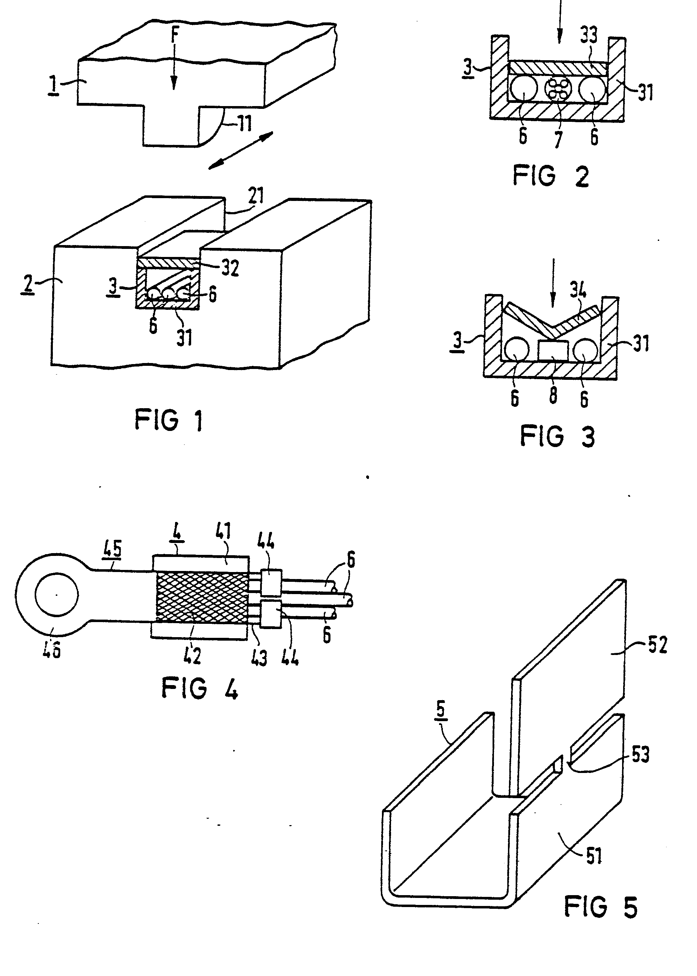

In der Fig. 1 bedeutet 1 die Sonotrode einer Ultraschallschweißeinrichtung. Die senkrecht nach unten wirkende Schweißkraft ist mit F gekennzeichnet. Dazu senkrecht in vorgegebener Horizontalebene verläuft die Schwingungsrichtung der Sonotrode 1 und des abgestrahlten Ultraschalls. In dieser Richtung ist die Wirkungsfläche 11 der Sonotrode 1 abgerundet ausgebildet. Die Wirkungsfläche 11 kann in sich profiliert sein.

Der Sonotrode 1 ist ein Amboß 2 zugeordnet, der mit einer Aussparung 21 als Aufnahmewerkzeug ausgebildet ist. In der Aussparung ist ein Ultraschallverbinder 3 eingelegt, der aus einem u-förmigen Profilteil 31 geformt ist. Auf dem Profilteil 31 liegt ein Deckel 32 auf. Zwischen Profilteil 31 und Deckel 32 sind Drähte 6 und/oder Litzen 7 sowie gegebenenfalls auch Endteile 8 von Anschlußelementen, welche miteinander verschweißt werden sollen, einlegbar.

Der eigentliche Vorgang des Ultraschallschweißens ist vom Stand der Technik bekannt. Beispielsweise werden dazu Ultraschallfrequenzen zwischen 16 und 20 kHz verwendet. Dabei wird die Sonotrode mit vorbestimmter Preßkraft F auf den Ultraschallverbinder aufgesetzt. Parameter bei der Ultraschallverschweißung sind neben dem Anpreßdruck die Schweißzeit und die Amplitude der Schwingungen. Typische Schweißzeiten liegen bei 0,7 bis 3s bei Amplituden von etwa 20 μm, während die Anpreßkraft zwischen 700 bis 1 200 N variierbar ist.

Während bei der Fig. 1 der Deckel 32 mit seiner Breite auf den Querschnitt des Profilteiles 31 abgestimmt ist und auf den Schenkeln des Profilteiles 31 aufliegt, ist bei den Figuren 2 und 3 die Breite des Deckels 33 bzw. 34 geringer gewählt und entspricht der Innenbreite des Profilteils 31. Der Deckel 33 bzw. 34 kann dadurch zwischen die Schenkel des Profilteiles 31 eingelegt werden, so daß er bereits ohne Verschweißung unmittelbar auf den Drähten 6 und/oder Litzen 7 zu liegen kommt. Dadurch kann sich eine besonders günstige Verschweißung insbesondere der Randbereiche ergeben. Die freistehenden Schenkel des Profilteiles 31 können anschließend an die Ultraschallverschweißung nach innen gefaltet werden.

Speziell bei Fig. 3 ist der Deckel 34 um seine Mittelspur geknickt, so daß sich im Querschnitt ein v-förmiges Profil ergibt. Hier wird durch die Ultraschalleinwirkung und die Schweißkraft ebenfalls erreicht, daß die Deckplatte 34 in das u-förmige Profilteil 31 eingedrückt und mit dessen Schenkeln sowie den eingelegten Drähten 6 und/oder Litzen 7 verschweißt wird. Dabei können die Drähte 6 und/oder Litzen 7 an ihren Berührungsstellen bereits bei geringer Verformung geschweißt werden.

In Fig. 4 ist der Ultraschallverbinder mit 4 bezeichnet. Dieser besteht an einem Ende — wie bereits beschrieben ebenfalls aus einem u-förmigen Profilteil 41 mit zugehörigem Deckel 42, während an der anderen Seite der Ultraschallverbinder 4 als Anschlußteil 45 ausgebildet ist. Ein solches Anschlußteil 45 kann in einfacher Weise als Öse 46 geformt sein, welche mittels einer zugehörigen Schraube oder dergleichen an die Anschlußstelle geschraubt und somit elektrisch kontaktiert ist.

Es ist zweckmäßig, die Drähte 6 bzw. Litzen 7 mittels einer Zugentlastung zu sichern : In Fig. 4 wird dies durch eine Verlängerung 43 des Profilteils 41 mit Klemmlaschen 44, die um die Anschlußleitungen herumgebogen werden, erreicht.

In Fig. 5 ist ein Ultraschallverbinder 5 derart ausgebildet, daß an einem u-förmigen Profilteil 51 ein zugehöriger Deckel 52 über einen Steg 53 angebunden ist. Statt des Steges 53 können auch mehrere kleine Anbindungen vorhanden sein.

Bei einer solchen Ausführungsform eines Ultraschallverbinders ist vorteilhaft, daß in der Fertigung lediglich ein einziges Teil ausgestanzt und zur Ultraschallverschweißeinrichtung zugeführt werden muß. Zum Schweißen selbst wird die Deckplatte 52 über die eingelegten Drähte und/oder Litzen geklappt. Da die Anbindung des Deckels 52 an das Profilteil 51 sehr schmal ausgebildet ist, kann die Deckplatte 52 beim Schweißen als aktives Teil ungehindert mitschwingen. Die Anbindungen können auch ganz oder teilweise beim Schweißen abreißen, so daß beim eigentlichen Schweißvorgang ein Ultraschallverbinder aus separatem aktiven und passiven Teil vorliegt.

Es hat sich gezeigt, daß das durch die Erfindung vorgeschlagene Anschlußverfahren in vielen Bereichen der Technik eingesetzt werden kann, wo lackierte Drähte und/oder Litzen untereinander und gegebenenfalls mit Anschlußelementen unlösbar verbunden werden sollen. Dabei ist es wichtig, daß die Art der Isolierung bzw. der Lackierungen auf den Drähten und/oder Litzen keinen Einfluß auf die Qualität und Zuverlässigkeit der Ultraschallschweißverbindung hat.

## Patentansprüche

1. Ultraschallverbinder zum Herstellen nichtlösbarer elektrischer Verbindungen von Drähten (6) und/oder Litzen (7) untereinander sowie von Drähten (6) und/oder Litzen (7) mit Anschlußelementen od. dgl. durch Ultraschallverschweißung, mit einem für die Ultraschallverschweißung dienenden, im wesentlichen ein U-Profil bildendem Formteil (3, 4, 5) zur Aufnahme der Drähte (6) und/oder Litzen (7) und gegebenenfalls der Anschlußelemente, dadurch gekennzeichnet, daß das Formteil (3, 4, 5) ein bei Kontakt mit einer Ultraschallsonotrode (1) frei mitschwingendes aktives Teil (32, 33, 42, 52) und ein nicht mitschwingendes passives Teil (31, 41, 51) als U-Profil umfaßt, wobei das aktive Teil (32, 33, 42, 52) einen Deckel für das passive Teil (31, 41, 51) bildet.

2. Ultraschallverbinder nach Anspruch 1, dadurch gekennzeichnet, daß die Breite des Deckels (32) der Außenbreite des Profilteiles (3) entspricht.

3. Ultraschallverbinder nach Anspruch 1, dadurch gekennzeichnet, daß die Breite des Deckels (33) der Innenbreite des Profilteils (31) entspricht.

4. Ultraschallverbinder nach Anspruch 3, dadurch gekennzeichnet, daß der Deckel (34) V-förmig gebogen ist.

5. Ultraschallverbinder nach Anspruch 1, dadurch gekennzeichnet, daß der Deckel (52) vor der bestimmungsgemäßen Anwendung über wenigstens eine Anbindung (53), beispielsweise einen Steg, mit dem U-Profil (51) verbunden ist.

6. Ultraschallverbinder nach Anspruch 1 oder 5, dadurch gekennzeichnet, daß das Profilteil (31, 41, 51) und der Deckel (32, 33, 34, 42, 52) aus gleichem gutschweißbarem Werkstoff, beispielsweise Kupfer, Messing oder Bronze bestehen.

7. Ultraschallverbinder nach Anspruch 1, dadurch gekennzeichnet, daß das Profilteil (31, 41, 51) und der Deckel (32, 33, 34, 42) aus unterschiedlichem, gut ultraschallschweißbarem Werkstoff bestehen, beispielsweise aus Kupfer einerseits und/oder Messing bzw. Bronze andererseits.

## Claims

1. An ultrasonic connector for establishing non-detachable electrical connections of solid wires (6) and/or stranded wires (7) to one another and of solid wires (6) and/or stranded wires (7) to terminal elements, or the like, by ultrasonic welding, having a shaped component (3, 4, 5) which serves for the ultrasonic welding, has essentially a U-section and accommodates the solid wires (6) and/or the stranded wires (7) and, where appropriate the terminal elements, characterised in that the shaped component (3, 4, 5) comprises an active part (32, 33, 42, 52) which resonates freely on contact with an ultrasonic sonotrode (1), and a non-resonant, passive part (31, 41, 51) as a U-section, the active part (32, 33, 42, 52) forming a cover for the passive part (31, 41, 51).

2. An ultrasonic connector as claimed in Claim 1, characterised in that the width of the cover (32) corresponds to the outer width of the U-section part (3).

3. An ultrasonic connector as claimed in Claim 1, characterised in that the width of the cover (33) corresponds to the inner width of the U-section part (31).

4. An ultrasonic connector as claimed in Claim 3, characterised in that the cover (34) is bent into a V-formation.

5. An ultrasonic connector as claimed in Claim 1, characterised in that before its destined use, the cover (52) is connected through at least one tie (53), for example, a bridge piece, to the U-section (51).

6. An ultrasonic connector as claimed in Claim 1 or 5, characterised in that the U-section part (31, 41, 51) and the cover (32, 33, 34, 42, 52) consist of the same easily weldable material, for example, copper, brass, or bronze.

7. An ultrasonic connector as claimed in Claim 1, characterised in that the U-section part (31, 41, 51) and the cover (32, 33, 34, 42) consist of different materials which can be easily welded by ultrasonics, for example, copper, on the one hand, and/or brass or bronze, on the other hand.

## Revendications

1. Connecteur pour soudage par ultrasons pour établir des connexions électriques non détachables entre des fils (6) et/ou des torons (7) et entre des fils (6) et/ou des torons (7) et des organes de raccordement ou analogues au moyen d'un soudage par ultrasons, comportant une pièce de forme (3, 4, 5) utilisée pour le soudage par ultrasons et constituant essentiellement un profilé en U et servant à loger les fils (6) et/ou les torons (7) et éventuellement les organes de raccordement, caractérisé par le fait que la pièce de forme (3, 4, 5) comporte, en tant que profilé en U, un élément actif (32, 3, 42, 52) cooscillant librement dans le cas du contact avec une sonotrode à ultrasons (1), et un elément passif (31, 41, 51) non cooscillant, l'élément actif (32, 33, 42, 52) constituant un couvercle pour l'élément passif (31, 41, 51).

2. Connecteur pour soudage par ultrasons suivant la revendication 1, caractérisé par le fait que la largeur du couvercle (32) correspond à la largeur extérieure de l'élément profilé (3).

3. Connecteur pour soudage par ultrasons suivant la revendication 1, caractérisé par le fait que la largeur du couvercle (33) correspond à la largeur intérieure de l'élément profilé (31).

4. Connecteur pour soudage par ultrasons suivant la revendication 3, caractérisé par le fait que le couvercle (34) est coudé en forme de V.

5. Connecteur pour soudage par ultrasons selon la revendication 1, caractérisé par le fait qu'avant son utilisation conformément aux prescriptions, le couvercle (52) est relié au profilé en U (51) au moyen d'un organe de liaison (53), par exemple une barrette.

6. Connecteur pour soudage par ultrasons suivant la revendication 1 ou 5, caractérisé par le fait que l'élément profilé (31, 41, 51) et le couvercle (32, 33, 34, 42, 52) sont constitués par le même matériau présentant une bonne aptitude au soudage, par exemple du cuivre, du laiton ou du bronze.

7. Connecteur pour soudage par ultrasons suivant la revendication 1, caractérisé par le fait que l'élément profilé (31, 41, 51) et le couvercle (32, 33, 34, 42) sont constitués en des matériaux différents, présentant une bonne aptitude au soudage par ultrasons, par exemple du cuivre d'une part et/ou du laiton ou du bronze d'autre part.

0 133 883

FIG 1

FIG 2

FIG 3

FIG 4

FIG 5